# EUROPÄISCHE PATENTSCHRIFT

(11) **EP 2 217 738 B1**
(45) Veröffentlichungstag und Bekanntmachung des Hinweises auf die Patenterteilung: **12.03.2014**
(21) Anmeldenummer: 08854039.8
(22) Anmeldetag: 01.11.2008
(51) Int. Cl.: C23C 14/22, C23C 16/44

(54) **VAKUUMKAMMER AUF RAHMENBASIS FÜR BESCHICHTUNGSANLAGEN**
FRAME-BASED VACUUM CHAMBER FOR COATING SYSTEMS
CHAMBRE À VIDE À BASE DE CADRE POUR DES DISPOSITIFS DE REVÊTEMENT

(30) Priorität: 28.11.2007 DE 102007057644
(43) Veröffentlichungstag der Anmeldung: 18.08.2010
(73) Patentinhaber: Oerlikon Trading AG, Trübbach, 9477 Trübbach (CH)
(72) Erfinder: ZÜND, Fredy, CH-9443 Widnau (CH); MAYER, Marco, FL-9494 Schaan (LI); KRASSNITZER, Siegfried, A-6800 Feldkirch (AT); GWEHENBERGER, Jürgen, CH-7323 Wangs (CH)
(74) Vertreter: Kempkens, Anke
(86) Internationale Anmeldenummer: PCT/EP2008/009233
(87) Internationale Veröffentlichungsnummer: WO 2009/068150

(56) Entgegenhaltungen:
- DE-U1- 9 404 022
- US-A1- 2007 090 629

## Beschreibung

Die vorliegende Erfindung bezieht sich auf eine Vakuumkammer. Die Erfindung bezieht sich insbesondere auf eine Vakuumkammer für Beschichtungsanlagen.

Die als PVD oder CVD bekannten Beschichtungsverfahren bezeichnen beispielsweise Beschichtungsverfahren unter Vakuumbedingungen. Bei der PVD (physical vapor deposition) beruht der Beschichtungsprozess im Wesentlichen auf physikalischer Abscheidung von Material auf einem zu beschichtenden Werkstück. Bei der CVD (chemical vapor deposition) beruht der Beschichtungsprozess im Wesentlichen auf chemischen Reaktionen. Beiden Verfahren ist gemein, dass sie oftmals unter Hochvakuumbedingungen (HV, 10⁻³mbar bis 10⁻⁷mbar) oder unter Ultrahochvakuumbedingungen (UHV, 10⁻⁷mbar bis 10⁻¹²mbar). Im Rahmen der vorliegenden Erfindung soll unter Vakuum der Zustand eines Fluids in einem Volumen bezeichnet werden mit einem Druck, der geringer ist als 10⁻¹ mbar.

Zur Erzeugung eines Vakuums wird in der Regel aus einer dicht verschlossenen Kammer ein Fluid abgepumpt. Typischerweise wird die Kammer aus einem einstückigen Kammerkörper, zumeist aus Edelstahl, hergestellt. Dies um mögliche Lecks zu verhindern und ein gutes Vakuum zu erzeugen.

In DE 9404022 U wird das Problem angesprochen, dass bei solchen herkömmlichen, aus einem einstückigen Kammerkörper gefertigten Kammern jede vorzunehmende Änderung mit größerem Aufwand (Trennen, Schweißen etc.) verbunden ist. DE 9404022 U offenbart die Merkmale nach dem Oberbegriff des Anspruchs 1. Dort wird daher vorgeschlagen, die Vakuumkammer von vorne herein nicht aus einem Stück herzustellen, sondern die Funktionsebenen (Target, Quellen- und Pumpebene) in flanschverbundene Bereiche zu unterteilen. Außerdem könne für spätere Erweiterungen der obere und untere Abschluß mit flanschverbundenen Deckeln erfolgen.

Diese Methode die Kammer in flanschverbundene Bereiche aufzuteilen hat zwar den Vorteil der erhöhten Flexibilität in Bezug auf vorzunehmende Änderungen. Letztlich führt dies aber dazu, dass bei einer Änderung dennoch erneut die Statik berechnet werden muss um sicher zu stellen, dass die aus den flanschverbundenen Teilen entstehende Kammer die erforderliche Stabilität aufweist, um den mit den Druckunterschieden (Kammerinneres im Vergleich zu Aussenraum) zusammenhängenden Kräften stand zu halten.

Es besteht daher ein Bedürfnis nach einer Vakuumkammer an der in einfacher und flexibler Weise Änderungen in Bezug auf Funktionselemente vorgenommen werden können, die aber gleichzeitig derart ausgelegt ist, dass unabhängig davon, wie die Funktionselemente konkret angeordnet sind, eine ausreichende Stabilität der Kammer gewährleistet ist.

Der Erfindung liegt daher die Aufgabe zugrunde diesem Bedürfnis nachzukommen, d.h. eine Vakuumkammer anzugeben, an der in einfacher und flexibler Weise Änderungen in Bezug auf Funktionselemente vorgenommen werden können, die aber gleichzeitig derart ausgelegt ist, dass unabhängig davon, wie die Funktionselemente konkret angeordnet sind, eine ausreichende Stabilität der Kammer gewährleistet ist.

Erfindungsgemäß wird die Aufgabe dadurch gelöst, dass die Kammer als Rahmenkonstruktion ausgeführt ist, in die Einsatzplatten eingesetzt sind. Der Rahmen bildet für die Kammer ein stabiles Gerüst. Auf den Einsatzplatten können An- und Einbaugeräte, wie zum Beispiel Pumpen, Target oder Quelle vormontiert sein. Die Einsatzplatten werden mit dem Rahmen mechanisch und vakuumdicht verbunden. Zur Herstellung mehrerer unterschiedlicher Vakuumkammern können Rahmen dabei als Modul in großer Anzahl standardisiert und damit mit niedrigen Kosten hergestellt werden. Im Falle spezifischer Kundenanforderungen muss der Rahmen überhaupt nicht mehr bearbeitet werden, da Kundenspezifikationen vollständig über die Anpassung der Einsatzplatten berücksichtigt werden können. Die daran vorgesehenen Funktionselemente, wie zum Beispiel Target, Quelle oder Vakuumpumpe, aber auch beispielsweise Sichtfenster können relativ zueinander von Kammer zu Kammer in unterschiedlicher Weise angeordnet werden. Da der Rahmen der Kammer die erforderliche Stabilität liefert, muss für eine solche Variation nicht jedes Mal von neuem die Statik der Kammer berechnet werden.

Die Erfindung wird im Folgenden anhand von Beispielen und mit der Hilfe von Bildern genauer erläutert.
Figur 1 zeigt den Rahmen einer erfindungsgemäßen Vakuumkammer.
Figur 2 zeigt eine erfindungsgemäße Vakuumkammer mit Rahmen gemäß Figur 1 und montierten Einsatzplatten.
Figur 3 zeigt die Kammer gemäß Figur 2 mit leicht geöffneter Türe
Figur 4a zeigt einen Teil des Innenbereiches einer erfindungsgemäßen Vakuumkammer
Figur 4b zeigt den der Figur 4a entsprechenden Teil von aussen gesehen.
Figur 5a zeigt die Frontansicht eines Ausschnittes des Rahmens einer erfindungsgemäßen Vakuumkammer.
Figur 5b den der Figur 5 a entsprechenden Querschnitt des Ausschnitts.
Figur 5c zeigt die Frontansicht einer Einsatzplatte einer erfindungsgemäßen Kammer.
Figur 5d zeigt den der Figur 5c entsprechenden Querschnitt.
Figur 5e zeigt eine perspektivische Ansicht vom Rahmenausschnitt und der Einsatzplatte des in den Figuren 5a bis 5d dargestellten Ausschnittes.
Figur 6a zeigt schematisch eine aus einer Materialplatte heraus getrennte flache Form die zu einem Bestandteil des Rahmens gebogen werden soll.
Figur 6b zeigt die Materialplatte aus Figur 6a, wobei bereits zwei der Arme nach oben zu Stegen gebogen sind.
Figur 6c zeigt die den Deckel mit dem die Materialplatte aus Figur 6b verbunden wird
Figur 7 zeigt einen Teil des Rahmenprofils in einer Ausführungsform, die ein einfaches, zentriertes Einsetzen der Einsatzplatte bei dennoch erhaltener Stabilität erlaubt.
Figur 8a zeigt eine Metallplatte mit Öffnungen die gebogen werden kann und Teil des Mantels des Kammerrahmens bilden kann
Figur 8b zeigt eine Metallplatte mit Öffnungen die gebogen werden kann und Teil der Türe des Kammerrahmens bilden kann
Figur 9 zeigt die Profile der in den Figuren 8a und 8b gezeigten Metallplatten und wie sie gebogen werden können um den Mantelrahmen zu bilden.
Figur 10 zeigt einen Teil des Rahmenprofils in einer Ausführungsform, die ein einfaches zentriertes einsetzen der Einsatzplatte bei dennoch erhaltener Stabilität erlaubt.

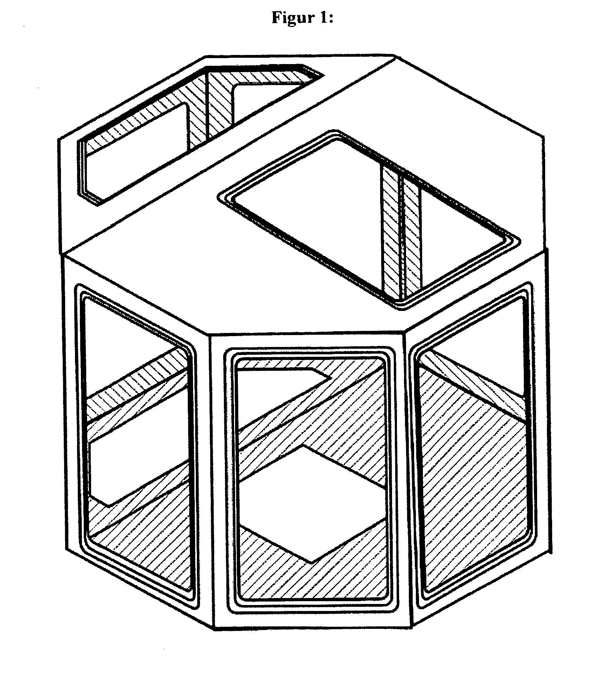

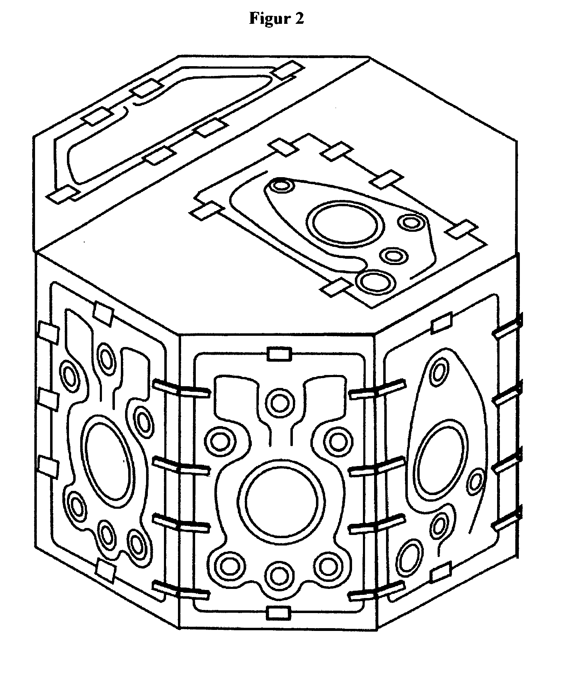

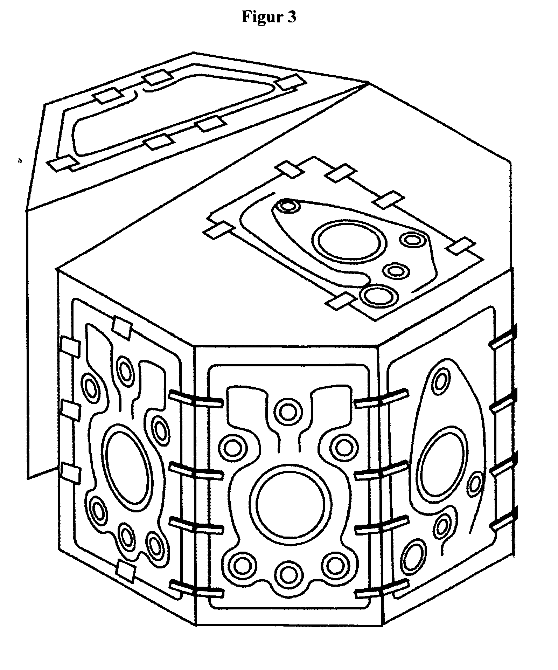

Bei dem in Figur 1 gezeigten Beispiel handelt es sich um ein reguläres Prisma, dessen Grundfläche ein regelmäßiges Achteck ist. Hierbei kann von einem Rahmen gesprochen werden, weil beim Mantel des Prismas lediglich im Bereich der Mantelkanten Material vorgesehen ist und dieses als Verbindungsstege ausgebildet ist. Die Verbindungsstege verbinden die Grundflächen des Prismas. Der Rahmen ist in der Lage Zug- Druck- und auch Biegebelastungen, wie sie in Vakuumkammern beispielsweise beim evakuieren Auftreten, aufzunehmen und dem standzuhalten. Zusätzliche Belastungen können ihre Ursache in einem beladenen Karussell, Belastung durch Kammertransport z.B. durch Kranösen haben. Aufgrund der Rahmenkonstruktion entstehen großflächige Öffnungen in die, wie die Figur 2 zeigt, Einsatzplatten 5 eingesetzt werden können. Gemäß Figur 1 sind zusätzlich in den Grundflächen großflächige Öffnungen vorgesehen. Auch hier werden Einsatzplatten 7 eingesetzt. Auch dies ist in Figur 2, die eine Ausführungsform einer vollständigen erfindungsgemäße Vakuumkammer zeigt, dargestellt. Lediglich angedeutet ist in Figur 2, dass die Vakuumkammer eine aufklappbare Türe umfasst. Abweichend von diesem Beispiel sind auch mehrere Türen möglich. Eine erfindungsgemäße Vakuumkammer mit geöffneter Türe ist in der Figur 3 dargestellt. Eine solche Türe ermöglicht einerseits das Bestücken der Kammer mit Werkstücken die einer Vakuumbehandlung unterzogen werden sollen. Relevant im Zusammenhang mit der vorliegenden Erfindung ist jedoch, dass die Türe es ermöglicht, die Einsatzplatten von aussen zu montieren und von Innen an dem Rahmen zu befestigen.

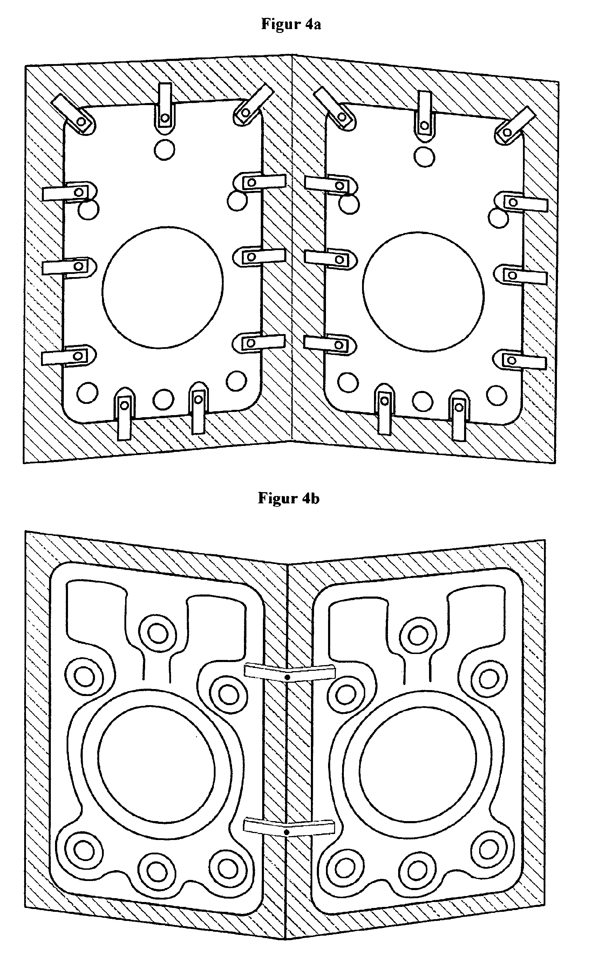

Die Figur 4a zeigt demgemäß einen Ausschnitt des Kammerinnenraumes mit einem Teil des Rahmens an dem Einsatzplatten lösbar mechanisch befestigt sind. In dem vorliegenden Beispiel sind die Einsatzplatten mittels Spanneisen an den Rahmen 3 gepratzt.

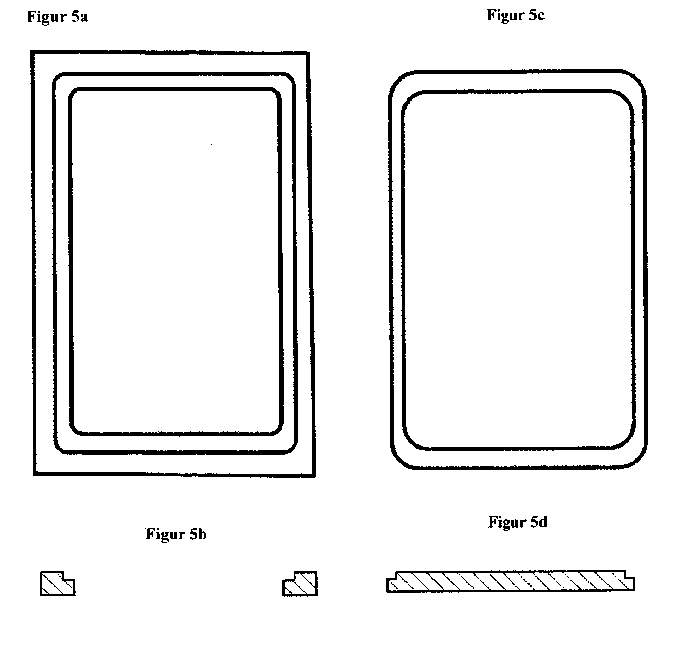

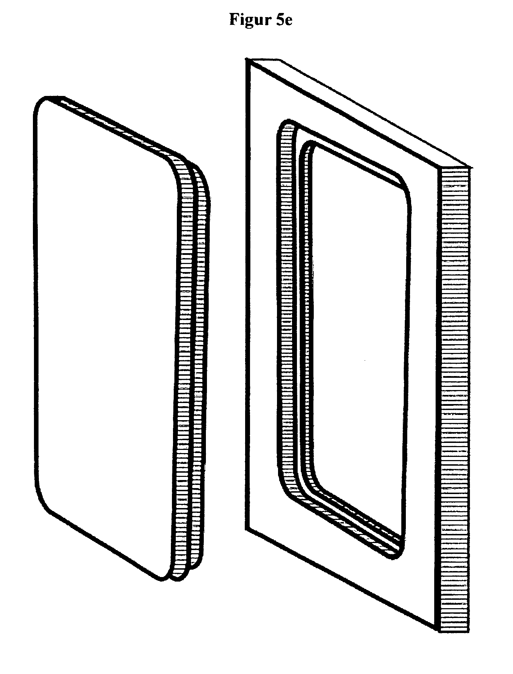

Das Randprofil der Einsatzplatten ist dem Randprofil des Rahmens angepasst, und zwar derart, dass eine erste Fläche der Einsatzplatten durch die durch den Rahmen gebildete Öffnung passt, während die der ersten Fläche gegenüberliegende zweite Fläche nicht durch die durch den Rahmen gebildete Öffnung passt. Dies kann beispielsweise durch ein treppenartiges Profil realisiert werden, wie in den Figuren 5a bis 5d dargestellt. Figur 5a zeigt die Frontansicht eines Ausschnittes des Rahmens während Figur 5b den dementsprechenden Querschnitt zeigt. Figur 5c zeigt die Frontansicht einer Einsatzplatte und Figur 5d den dementsprechenden Querschnitt. Figur 5e zeigt eine perspektivische Ansicht vom Rahmenausschnitt und der Einsatzplatte. In den Figuren 5a bis 5e sind eventuell in der Einsatzplatte vorgesehene Strukturen wie z.B. Flansche mit Löchern oder Kanäle für Heizung oder Kühlung nicht gezeigt da es in der Darstellung um das Profil und das Zusammenwirken von Rahmen und Einsatzplatte geht. Das Treppenprofil erlaubt es in den Stufen abdichtende O-Ringe, die typischerweise aus einem elastischen Material gefertigt sind, beispielsweise Gummi, vorzusehen. Es ist möglich solche O-Ringe entweder in den Stufen der Einsatzplatten oder in den Stufen des Rahmens, oder auch in beiden vorzusehen. Andere, dem Fachmann bekannte Dichtungsarten können auch eingesetzt werden.

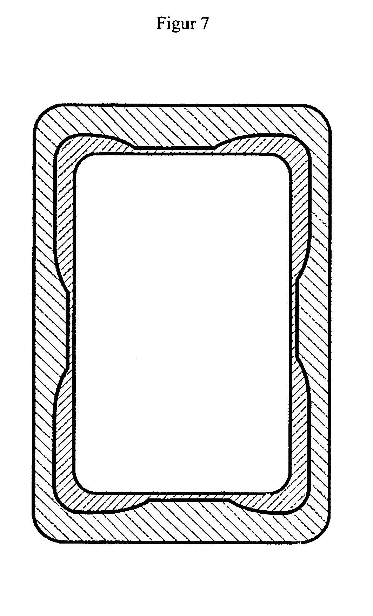

Unter anderem aus Fertigungsgründen, sowie um ein einfacheres einsetzen der Einsatzplatten zu erlauben ist es von Vorteil zwischen Rahmen und Einsatzplatten Spiel zu lassen. Durchaus möglich und bevorzugt sind hierbei ca. 4mm. Allerdings kann man dann, um dem Rahmen und damit der Kammer zusätzlich Stabilität im Rahmen sich verdickende Stellen vorsehen an denen sich die Einsatzplatte mit grösserer Genauigkeit einfügen lassen. Diese gereichen nicht nur zur Stabilisierung, sondern helfen auch bei der Justage, insbesondere bei der Zentrierung der Einsatzplatten. Figur 7 zeigt ein Beispiel solcher verdickten, stabilisierenden und zentrierenden Stellen. In der Figur 7 sind diese aus darstellerischen Gründen übertrieben dargestellt.

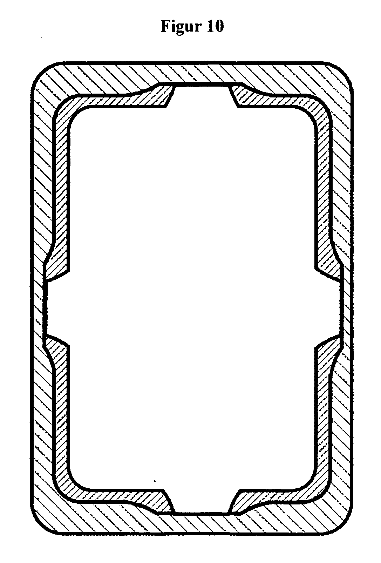

Eine weitere Ausführungsform ist in Figur 10 schematisch abgebildet. Dabei sind im Rahmen beispielsweise vier Ausnehmungen realisiert. Die Einsatzplatten haben demgegenüber vier Ausformungen, die sich beim Einsatz der Einsatzplatten in den Rahmen justiert einführen. Ein Vorteil einer solchen Realisation ist zudem, dass in dem Fall die Berandung der im Rahmen vorgesehenen Öffnungen mit grosser Toleranz zunächst ohne die Ausnehmungen gefertigt werden kann, und anschliessend die Ausnehmungen genauer, d.h. mit geringerer Toleranz realisiert werden können. Entsprechendes gilt für die Berandung der Einsatzplatten und die daran vorgesehenen Einsatzplatten.

Dargestellt werden soll hier lediglich das Prinzip. Es ist auch möglich ein solches Mittel zu Stabilisierung an den Einsatzplatten vorzusehen. Unter Stabilisierung ist im Rahmen dieser Beschreibung die Festigung der Kammer zu verstehen. Bei all dem ist aber jeweils wichtig, dass die Einsatzplatten den Innenraum der Kammer Luftdicht abschliessen.

Die Figur 4b zeigt den der Figur 4a entsprechenden Teil der Vakuumkammer von aussen gesehen. Die in Figur 4b dargestellte Pratze ist eine Alternative zur innen gepratzten Variante in Figur 4a. Es kann aber auch von aussen und von innen gepratzt werden.

Die zur Beschreibung der vorliegenden Erfindung gewählten Beispiele sollen diese lediglich illustrieren, der Rahmen der Erfindung soll aber keinesfalls auf diese Beispiele beschränkt sein.

Beispielsweise lassen sich auf diese Weise auch Kammern realisieren die mehrere Türen haben. Es lassen sich auch solche Kammern realisieren die Toplader oder Bodenlader sind. Dies ist besonders dann interessant wenn Kammerhöhen erreicht werden sollen die deutlich über 1.5m gehen. Wird eine solche, beispielsweise 3m hohe Kammer mit lediglich einen Rahmen realisiert, so kommt man mit der Stabilität der Stege an einen kritischen Punkt und der Rahmen droht sich unter dem Aussendruck zu verbiegen. Dies kann verhindert werden, indem beispielsweise auf halber Höhe der Kammer ein zusätzliches, den ganzen radialen Umfang der Kammer umfassendes stabilisierendes, geschlossenes Polygon vorsieht. Als Alternative können zum gebogenen Mantel zusätzliche Versteifungsrippen (z.B. Streben wie bei einer Brücke) angebracht werden um die Stabilität zu gewährleisten und den Vorteil des einfachen Mantels zu erhalten.

Es ist darauf hinzuweisen dass, anstatt an einer der durch den Rahmen gebildeten Löcher eine abschliessende Einsatzplatte vorzusehen, beispielsweise über ein Adapterstück ein weiterer Rahmen angeordnet werden kann und auf diese Weise die Kammer auch seitlich vergrössert werden kann.

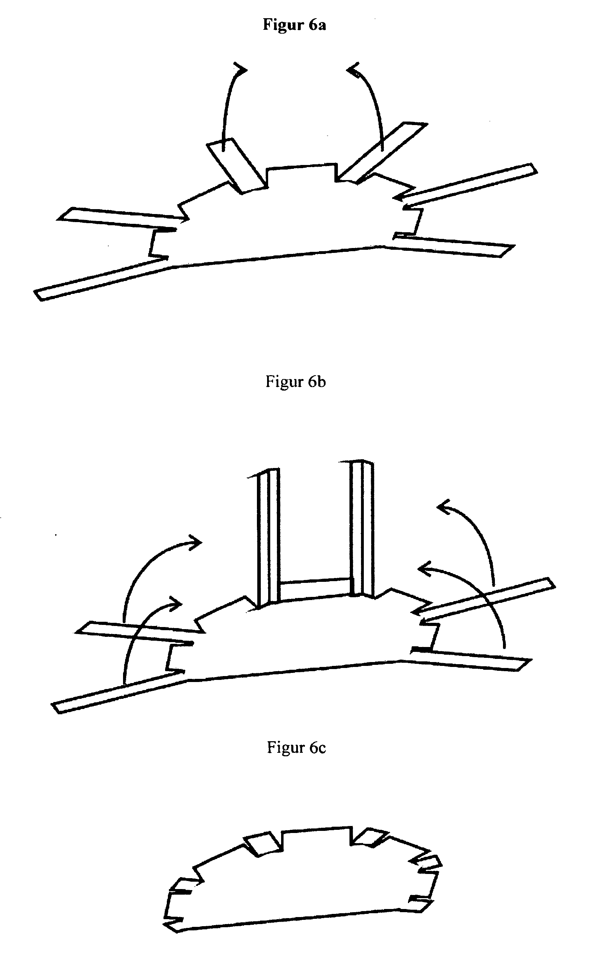

Vorteilhaft bei der vorliegenden Erfindung, wie zum Beispiel in Figur 6a dargestellt ist auch, dass wesentliche Bestandteile des Rahmens aus lediglich einer einstückigen Materialplatte hergestellt werden kann. Hierzu wird beispielsweise die aus einer Platte die Grundfläche des Rahmens mit einer den Stegen des Rahmens entsprechenden Anzahl von Armen herausgearbeitet. Zwischen den Armen sind an der Grundfläche Vorsprünge vorgesehen. Dies ist in der Figur 6a schematisch dargestellt. Die Arme werden dann anschliessend nach oben gebogen. Auch die Vorsprünge werden nach oben gebogen. In Figur 6b ist die Situation dargestellt bei der noch nicht alle Arme vollständig nach oben gebogen wurden und lediglich ein Vorsprung nach oben gebogen wurde. Die Seitenkanten der Vorsprünge werden mit den Stegen vakuumdicht verschweisst. Man kann die Stabilität dieser so entstehenden Stege dadurch erhöhen, dass sie längs des Stegverlaufs gebogen werden und beispielsweise eine längs verlaufenden Knick aufweisen. Als Material eignet sich beispielsweise Walzblech oder eine Metallplatte.

Zur Fertigstellung des Rahmens muss nun lediglich noch eine Deckelfläche mit den Enden der zu Stegen gewordenen Arme verbunden werden, beispielsweise durch schweißen. Die Deckelfläche kann dabei im Wesentlichen die gleiche Form aufweisen wie die Grundfläche, wobei die Arme zu Vorsprüngen verkürzt sind. Dies ist in Figur 6c gezeigt. In den Figuren 6a bis 6c gezeigt ist der Teil des Rahmens der 5 Löcher für Einsatzplatten bildet und das anbringen einer Türe gestattet. Der Rahmen der Türe kann in analoger Weise hergestellt werden.

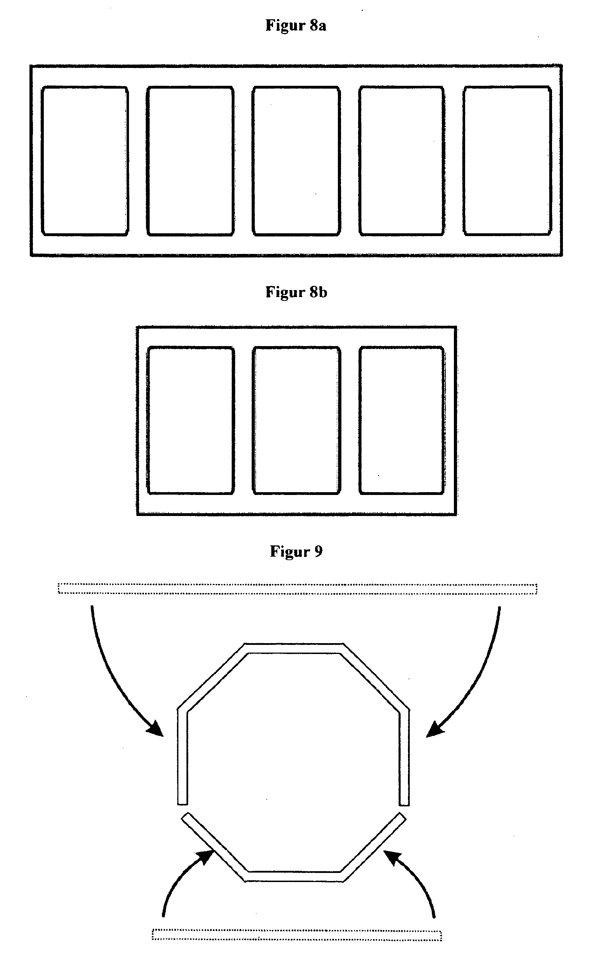

Gemäß einem etwas modifizierten Verfahren wird der Mantel der Kammer aus einer ersten Metallplatte und einer zweiten, die Türe bildende Metallplatte geformt. Die Breite der Platten entspricht dabei in etwa der Höhe der Kammer. Die für die Einsatzplatten vorzusehenden Öffnungen werden aus den Metallplatten herausgeschnitten. Dies hat den Vorteil, dass dort, wo die Einzelplatten eingesetzt werden, keine Schweissnähte nötig sind. Im wie in Figur 8a dargestellten Beispiel sind dies 5 Öffnungen die erste Metallplatte, die nicht die Türe bildet. Im in der Figur 8b dargestellten Beispiel sind für die zweite, den Rahmen für die Türe bildende Metallplatte drei Öffnungen vorgesehen.

Einem nächsten Schritt werden die Platten entsprechend der Mantelform der Kammer gebogen, In Figur 9 sind beide Metallplatten im Profil in ungebogener Form gestrichelt dargestellt und nach dem Biegen mit durchgezogener Linie dargestellt. Die Pfeile deuten die Biegerichtung an. Für eine bis zu 1.5 Meter hohe Kammer eignet sich eine Plattendicke von 10mm bis zu 30mm. Unterhalb 10mm läuft man Gefahr dass die Stabilität des Rahmens für den durch das Vakuum entstehenden Druck nicht ausreicht. Oberhalb von 30mm wird es schwierig das Blech entsprechend den Vorgaben zu Biegen. Idealerweise wird eine Plattenstärke von ca. 15mm verwendet.

Zur Vervollständigung des Kammerrahmens wird dann noch der Boden und der Deckel am Mantel, beispielsweise durch verschweissen, angebracht, sowie die Türe beispielsweise mit Scharnieren befestigt. Dies ist nicht in der Figur dargestellt. Durch Einsatz der Einsatzplatten in die im Mantel und/oder im Boden und/oder im Deckel vorgesehenen Öffnungen wird dann die Kammer gebildet.

Es wurde eine Vakuumkammer für Beschichtungsanlagen, bei der Funktionselemente an der Kammer angeordnet sind beschrieben die dadurch gekennzeichnet ist, dass die Kammer einen Kammerrahmen umfasst und in den Rahmen Einsatzplatten mechanisch lösbar und vakuumdicht eingesetzt sind und einige der Einsatzplatten Funktionselemente tragen.

Es wurde ausserdem eine Vakuumkammer für Beschichtungsanlagen beschrieben, bei der Funktionselemente an der Kammer angeordnet sind, wobei die Kammer einen Kammerrahmen umfasst und in den Rahmen Einsatzplatten mechanisch lösbar und dicht eingesetzt sind und einige der Einsatzplatten Funktionselemente tragen, dadurch gekennzeichnet, dass der Kammerrahmen zumindest eine aus einer einstückigen Metallplatte geformte, mit Armen versehene Grundfläche umfasst wobei die Arme im Bereich des Anschlusses an die Grundfläche dergestalt gebogen sind, dass sie Stege des Kammerahmens bilden.

Vorzugsweise wird die Oberfläche des von der Kammer umspannten Volumens zu mindestens 40%, besonders bevorzugt zu mindestens 50% durch die Einsatzplatten begrenzt.

Gemäss einer Ausführungsform der Vakuumkammer sind die Funktionselemente und die Einsatzplatten mit Flanschverbindungen, vorzugsweise mittels vorgesehenen Pratzen, lösbar verbunden sind. Besonders bevorzugt sind die Pratzen lediglich an den an den Einsatzplatten vorgesehen.

Gemäß einer Ausführungsform der erfindungsgemäßen Vakuumkammer sind zumindest einige, vorzugsweise alle Funktionselemente und die Einsatzplatten mit Flanschverbindungen mechanisch lösbar verbunden sind.

Der Aufbau der Kammer wird dann besonders flexibel wenn zumindest zwei, vorzugsweise mehrere durch den Rahmen gebildete Öffnungen geometrisch im Wesentlichen dieselbe Form haben und dadurch mindestens zwei, vorzugsweise mehrere Einsatzplatten durch mechanisches Lösen und Befestigen in ihrer Position ausgetauscht werden können.

Die Einsatzplatten sind nicht notwendigerweise ebene Platten. Ebene Platten sind im Verbindungsbereich mit dem Rahmen aber vorzuziehen. Die Einsatzplatten können aber auch als Topfform (aussen/innen gewölbt) angeflanscht werden

Der Rahmen erlangt dann besondere Stabilität wenn er im Wesentlichen in Bezug auf eine Achse eine n-zählige Symmetrie aufweist, wobei n eine ganze Zahl größer 2 ist und Einsatzplatten in einer der Symmetrie des Rahmens entsprechenden Weise eingesetzt sind.

Zu bevorzugen sind Varianten mit 6-, 8- oder 10-zähliger Symmetrie.

Ausserdem wurde ein Verfahren zur Herstellung einer Vakuumkammer offenbart, bei dem zur Herstellung eines Rahmens aus einer Materialplatte eine mit Armen versehene Grundfläche herausgearbeitet wird und die Arme derart aus der Ebene der Platte gebogen werden, dass sie geeignet sind die Stege des Rahmens zu bilden und anschliessen eine gegebenenfalls zu einem Rahmen degradierte Deckenplatte mit den Stegen verbunden wird und bei dem in die durch den Rahmen entstandenen Löcher Einsatzplatten und gegebenenfalls eine oder mehrere Türen eingesetzt werden, die im Zusammenspiel einen evakuierbaren abgeschlossenen Raum bilden. Dies gilt beispielsweise auch für die Alternative Variante nach Figur 8.

Abschliessend werden noch ein paar Möglichkeiten aufgelistet die mit der vorliegenden Erfindung zu verwirklichen sind Beispielsweise sind keine Gewindelöcher im Mantelrahmen notwendig zur Befestigung der Einsatzplatten. Durch das Biegen der Mantelflächen kann eine Schweissnaht im Bereich der Einsetzplatten vermieden werden

Es können, als Variante, Ausschnitte in der Mantelfläche für Funktionsbaugruppen vorgesehen sein, beispielsweise ohne das Einsatzplattenkonzept, aber nach dem gleichen Pratzensystem wie oben beschrieben. Ausserdem können weitere Kammern beispielsweise über das Pratzensystem vernetzt werden. Auf diese Weise kann eine Anlagenplattform entstehen.

Ausserdem kann eine Einsatzplatte auch als Türe ausgebildet werden um mehrere Funktionen - wie zum Beispiel heizen, beschichten - pro Seite, zu realisieren. Als Material für den Rahmen kommt nicht nur Edelstahl in Frage. Beispielsweise können auch Alulegierungen verwendet werden, was zu verminderten Materialkosten und zu einer Gewichtreduktion führen kann.
Alternativ oder zusätzlich zum gebogenen Mantel können zusätzliche Versteifungsrippen, z.B. Streben wie bei einer Brücke, angebracht werden um die Stabilität zu gewährleisten und den Vorteil des einfachen Mantels zu erhalten.

## Patentansprüche

1. Vakuumkammer für Beschichtungsanlagen, bei der Funktionselemente an der Kammer angeordnet sind, wobei die Kammer einen Kammerrahmen umfasst und in den Rahmen Einsatzplatten mechanisch lösbar und dicht eingesetzt sind und einige der Einsatzplatten Funktionselemente tragen, **dadurch gekennzeichnet, dass** der Kammerrahmen zumindest eine aus einer einstückigen Metallplatte geformte, mit Armen versehene Grundfläche umfasst wobei die Arme im Bereich des Anschlusses an die Grundfläche dergestalt gebogen sind, dass sie Stege des Kammerahmens bilden.

2. Vakuumkammer nach Anspruch 1, **dadurch gekennzeichnet, dass** die Oberfläche des von der Kammer umspannten Volumens zu mindestens 40%, vorzugsweise zu mindestens 50% durch die Einsatzplatten begrenzt wird.

3. Vakuumkammern nach einem der vorangehenden Ansprüche, **dadurch gekennzeichnet, dass** die Funktionselemente und die Einsatzplatten mit Flanschverbindungen, vorzugsweise mittels an den Einsatzplatten vorgesehenen Pratzen, lösbar verbunden sind.

4. Vakuumkammer nach einem der vorangehenden Ansprüche, **dadurch gekennzeichnet, dass** die zumindest zwei, vorzugsweise mehrere durch den Rahmen gebildete Öffnungen geometrisch im Wesentlichen dieselbe Form haben und dadurch mindestens zwei, vorzugsweise mehrere Einsatzplatten durch mechanisches Lösen und Befestigen in ihrer Position ausgetauscht werden können.

5. Vakkuumkammer nach einem der vorangehenden Ansprüche, **dadurch gekennzeichnet, dass** die Einsatzplatten zumindest im Verbindungsbereich mit dem Rahmen ebene Platten sind.

6. Vakkuumkammer nach einem der vorangehenden Ansprüche, **dadurch gekennzeichnet, dass** der Rahmen im Wesentlichen in Bezug auf eine Achse eine n-zählige Symmetrie aufweist, wobei n eine ganze Zahl größer 2 ist und Einsatzplatten in einer der Symmetrie des Rahmens entsprechenden Weise eingesetzt sind.

## Claims

1. Vacuum chamber for coating equipment which has functional elements arranged on the chamber, wherein the chamber comprises a chamber frame and insertable plates are inserted into the frame in a mechanically detachable and tight manner and some of the insertable plates comprise functional elements **characterized in that** the chamber frame comprises at least one base area formed by an integral metal plate and mounted with legs, the legs being curved in the region of attachment to the base area such that they form bars of the chamber frame.

2. Vacuum chamber according to claim 1, **characterized in that** the surface of the volume held by the chamber is at least 40%, preferably at least 50 % limited by the insertable plates.

3. Vacuum chamber according to one of the preceding claims, **characterized in that** the functional elements and the insertable plates are detachably connected to each other by way of connecting flanges, preferably by way of mounting brackets provided on the insertable plates.

4. Vacuum chamber according to one of the preceding claims, **characterized in that** the at least two, preferably more orifices formed by the frame essentially have the same geometrical shape thereby allowing substitution of at least two, preferably more insertable plates by way of mechanical detachment and fixation to their positions.

5. Vacuum chamber according to one of the preceding claims, **characterized in that** the insertable plates are plates which at least are plane in the attachment region of the frame.

6. Vacuum chamber according to one of the preceding claims, **characterized in that** the frame has n-fold symmetry in relation to an axis, wherein n is an integer of greater than 2 and insertable plates are inserted in a manner corresponding to the symmetry of the frame.

## Revendications

1. Chambre sous vide pour des installations de revêtement, qui a des éléments de fonction arrangés sur la chambre, dans laquelle la chambre comprend un cadre de la chambre, et des plaques d'insertion sont insérées dans le cadre de façon mécaniquement amovible et étanche et quelques-unes des plaques d'insertion portent au moins des éléments de fonction, **caractérisé par le fait que** le cadre de chambre comprend au moins une superficie de base formée d'une plaque de métal qui est réalisée d'un seul tenant, et munie de bras, les bras étant courbés dans la région de raccordement à la superficie de base d'une façon telle qu'ils forment des âmes du cadre de la chambre.

2. Chambre sous vide selon la revendication 1, **caractérisé par le fait que** la surface du volume contenu dans la chambre est limité au moins 40 %, préférablement au moins 50 % par les plaques d'insertion.

3. Chambre sous vide selon l'une des revendications précédentes, **caractérisé par le fait que** les éléments de fonction et les plaques d'insertion sont raccordés de façon amovible par des raccords à brides, préférablement au moyen des griffes prévues sur les plaques d'insertion.

4. Chambre sous vide selon l'une des revendications précédentes, **caractérisé par le fait que** les au moins deux ouvertures, préférablement plusieurs des ouvertures formées par le cadre sensiblement ont la même forme géométrique, et permettant de ce fait le remplacement d'au moins deux, préférablement de plusieurs plaques d'insertion par desserrage et fixation de façon mécanique dans leur positions.

5. Chambre sous vide selon l'une des revendications précédentes, **caractérisé par le fait que** les plaques d'insertion sont de plaques plan au moins dans la région de raccordement au cadre.

6. Chambre sous vide selon l'une des revendications précédentes, **caractérisé par le fait que** le cadre a une symétrie d'ordre n relatif à une axe, dans laquelle n est un nombre entier supérieur à 2 et des plaques d'insertion sont insérées de façon correspondant à la symétrie du cadre.
